# EUROPEAN PATENT APPLICATION

(11) **EP 4 513 213 A1**
(43) Date of publication of application: **26.02.2025**
(21) Application number: 23838477.0
(22) Date of filing: 13.04.2023
(51) Int. Cl.: G01R 31/69

(54) **TYPE-C INSERTION DIRECTION DETECTION CIRCUIT, CIRCUIT BOARD AND ELECTRONIC DEVICE**

(30) Priority: 12.07.2022 CN 202210815132
(71) Applicant: ZTE Corporation, Shenzhen, Guangdong 518057 (CN)
(72) Inventor: SUN, Quan, Shenzhen, Guangdong 518057 (CN); MAO, Rui, Shenzhen, Guangdong 518057 (CN)
(74) Representative: Carangelo, Pierluigi
(86) International application number: PCT/CN2023/088147
(87) International publication number: WO 2024/011975

(57) **Abstract**

A Type-C insertion direction detection circuit, a circuit board and an electronic device, which relate to the technical field of detection circuits. The detection circuit is applied to an electronic device, the electronic device comprising a Type-C socket. The detection circuit comprises: a switch module, wherein an input end of the switch module is configured to be connected to a VBUS end of the Type-C socket, the input end of the switch module is connected to a first CC end and/or a second CC end of the Type-C socket, and the switch module is configured to change the on/off state according to a first level, which is input by the first CC end and/or the second CC end and is received at the input end, and output a second level at a drive end of the switch module, so that the electronic device determines a plugging relationship between a Type-C plug and the Type-C socket according to the second level.

## Description

### CROSS-REFERENCE TO RELATED APPLICATION

This application is filed on the basis of Chinese patent application No. 202210815132.4 filed July 12, 2022, and claims priority to the Chinese patent application, the entire contents of which are incorporated herein by reference.

### TECHNICAL FIELD

The present disclosure relates to, but not limited to, the technical field of detection circuits, and more particularly, to a Type-C insertion direction detection circuit, a circuit board, and an electronic device.

### BACKGROUND

In the related technology, a special Type-C insertion direction detection chip is used to detect the Type-C insertion direction. However, the use of such a chip incurs high costs, and it may become unstable after prolonged use under software control, potentially affecting the accuracy of Type-C insertion direction detection.

### SUMMARY

The following is a summary of the subject matter set forth in this description. This summary is not intended to limit the scope of protection of the claims.

Embodiments of the present disclosure provide a Type-C insertion direction detection circuit, a circuit board, and an electronic device.

In accordance with a first aspect of the present disclosure, an embodiment provides a Type-C insertion direction detection circuit, applied to an electronic device including a Type-C socket. The detection circuit includes a switch module. An input end of the switch module is configured to be connected to a VBUS end of the Type-C socket. The input end of the switch module is connected to a first CC end and/or a second CC end of the Type-C socket. The switch module is configured to change an on/off status according to a first level received at the input end from the first CC end and/or the second CC end, and output a second level at a drive end of the switch module, for the electronic device to determine a plugging relationship between a Type-C plug and the Type-C socket according to the second level.

In accordance with a second aspect of the present disclosure, an embodiment provides a circuit board, including the detection circuit according to any of the embodiments of the first aspect.

In accordance with a third aspect of the present disclosure, an embodiment provides an electronic device, including the circuit board according to any of the embodiments of the second aspect.

Additional features and advantages of the present disclosure will be set forth in the description which follows, and in part will be apparent from the description, or may be learned by the practice of the present disclosure. The objects and other advantages of the present disclosure can be realized and obtained by the structures particularly pointed out in the description, claims and drawings.

### BRIEF DESCRIPTION OF DRAWINGS

The drawings are provided for a further understanding of the technical schemes of the present disclosure, and constitute a part of the description. The drawings and the embodiments of the present disclosure are used to illustrate the technical schemes of the present disclosure, but are not intended to limit the technical schemes of the present disclosure.
FIG. 1 is a circuit diagram of a Type-C insertion direction detection circuit according to an embodiment of the present disclosure;
FIG. 2 is a circuit diagram of a Type-C insertion direction detection circuit according to another embodiment of the present disclosure;
FIG. 3 is a circuit diagram of a Type-C insertion direction detection circuit according to still another embodiment of the present disclosure;
FIG. 4 is a schematic diagram of a circuit board according to an embodiment of the present disclosure; and

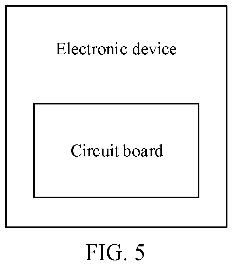

FIG. 5 is a schematic diagram of an electronic device according to an embodiment of the present disclosure.

### DETAILED DESCRIPTION

To make the objects, technical schemes, and advantages of the present disclosure clear, the present disclosure is described in further detail in conjunction with accompanying drawings and embodiments. It should be understood that the specific embodiments described herein are merely used for illustrating the present disclosure, and are not intended to limit the present disclosure.

It is to be noted, although functional modules have been divided in the schematic diagrams of apparatuses and logical orders have been shown in the flowcharts, in some cases, the modules may be divided in a different manner, or the steps shown or described may be executed in an order different from the orders as shown in the flowcharts. The terms such as "first", "second" and the like in the description, the claims, and the accompanying drawings are used to distinguish similar objects, and are not necessarily used to describe a specific sequence or a precedence order.

It should also be understood that reference to "an embodiment", "one embodiment", "some embodiments", or the like described in the description of the embodiments of the present disclosure means that particular characteristics, structures, or features described in connection with the embodiment are included in one or more embodiments of the present disclosure. Therefore, phrases such as "in an embodiment," "in one embodiment," "in some embodiments," and "in some other embodiments" appearing at different positions in the specification do not necessarily all refer to the same embodiment, but mean "one or more embodiments, not all embodiments," unless otherwise particularly stated. The terms such as "include", "comprise", "have" and variants thereof all mean "including but not limited to", unless otherwise particularly stated.

In recent years, most devices adopt Type-C as the interface type of electronic devices. Type-C is a new universal serial bus (USB) hardware interface form specified in the latest USB3.1 standard. Type-C is a brand-new interface developed by the USB standardization organization to solve the shortcomings such as long-standing inconsistencies in the physical interface specifications for USB interfaces and that electrical power can only be transmitted in one direction. Its biggest feature in appearance is that its upper and lower ends are identical, and two directions of insertion are supported, as compared with Micro-USB that requires the user to distinguish between the front and back sides of USB. Type-C integrates charging, display, data transmission, and other functions. Because of its excellent performance, Type-C has been widely used in the field of electronic devices. At present, almost all new generation mobile communication devices support Type-C interfaces. In the related art, a special Type-C insertion direction detection chip is used to detect the Type-C insertion direction, i.e., whether a CC pin on a socket is connected to a CC1 pin or a CC2 pin in a plug is detected by a program, so as to determine whether the Type-C plug is inserted from an A side or a B side, and thus control the switching position of USB3.0. However, for such a method, the chip may fail to stably operate after long-term use under the control of software, affecting the detection of the Type-C insertion direction.

The embodiments of the present disclosure will be further described in detail below with reference to the accompanying drawings.

In accordance with a first aspect of the present disclosure, an embodiment provides a Type-C insertion direction detection circuit, which is applied to an electronic device. The detection circuit includes a switch module. An input end of the switch module is configured to be connected to a VBUS end of a Type-C socket. The input end of the switch module is connected to a first CC end and/or a second CC end of the Type-C socket. The switch module is configured to change an on/off status according to a first level received at the input end from the first CC end and/or the second CC end, and output a second level at a drive end of the switch module, for the electronic device to determine a plugging relationship between a Type-C plug and the Type-C socket according to the second level. The switch module is connected to the Type-C socket. The VBUS end serves as an input end to provide voltage guarantee for an output level of an output end. The switch module changes its on/off status according to a level of the first CC end and/or the second CC end through internal electronic components, to change the current flow status from the input end to the output end. The drive end is configured to feed back the plugging relationship between the Type-C plug and the Type-C socket, i.e., feed back whether the Type-C plug is inserted from the A side or the B side. In the present disclosure, the insertion direction of the Type-C plug can be detected by the electronic components in the switch module, thereby effectively reducing the circuit costs and improving the reliability of the circuit.

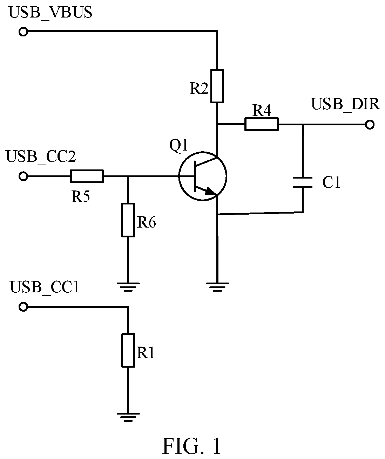

Referring to FIG. 1, in an embodiment, when the electronic device is a Device-type device, i.e., a driving device, the first CC end of the Type-C socket is grounded through a first resistor R1, the switch module includes a first switching tube Q1, an input end of the first switching tube Q1 is connected to the VBUS end, a control end of the first switching tube Q1 is connected to the second CC end, and an output end of the first switching tube Q1 is grounded. The detection circuit further includes a delay filter circuit. An input end of the delay filter circuit is connected between the input end of the first switching tube Q1 and the VBUS end, and an output end of the delay filter circuit is the drive end. In the circuit provided in this embodiment, when the Type-C plug is inserted into the Type-C socket from the A side, the USB_VBUS end is at a high level, the USB_CC1 is at a high level, and the USB_CC2 is at a low level. In this case, the first switching tube Q1 is not turned on, and the drive end USB_DIR is at a high level. When the Type-C plug is inserted into the Type-C socket from the B side, the USB_VBUS end is at a high level, the USB_CC1 is at a low level, and the USB_CC2 is at a high level. In this case, the first switching tube Q1 is turned on, a current flows directly from the USB_VBUS through Q1 to the ground without passing through the delay filter circuit, and the drive end USB_DIR is at a low level. In other words, in this embodiment, when it is detected that the USB_DIR is at a high level, it indicates that the insertion direction of Type-C is insertion from the A side, and when it is detected that the USB_DIR is at a low level, it indicates that the insertion direction of Type-C is insertion from the B side. In an embodiment, the first resistor R1 has a resistance of 5.1 kΩ, which is not limited in the present disclosure.

It should be noted that the Device-type device may be a memory device, such as a USB flash drive, an MP3 electronic device, a hard disk, etc.

Still referring to FIG. 1, a second resistor R2 is arranged between the input end of the first switching tube Q1 and the VBUS end, and the second resistor R2 is a pull-up resistor, such that the input end of the first switching tube Q1 is maintained at a high level and the stability of the detection circuit is improved. In an embodiment, the second resistor R2 has a resistance of 47 kΩ, which is not limited in the present disclosure.

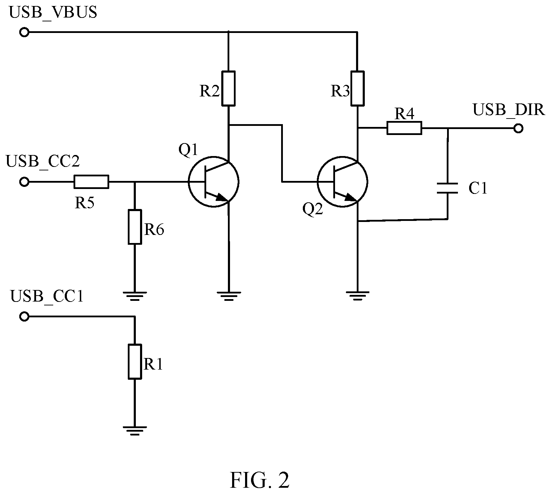

Referring to FIG. 2, the switch module further includes a second switching tube Q2 arranged between the input end of the first switching tube Q1 and the delay filter circuit, an input end of the second switching tube Q2 is connected to the VBUS end through a third resistor R3, a control end of the second switching tube Q2 is connected between the input end of the first switching tube Q1 and the second resistor R2, an output end of the second switching tube Q2 is grounded, and the input end of the delay filter circuit is connected between the input end of the second switching tube Q2 and the third resistor R3. To synchronize the level of the drive end USB_DIR with the level of the second CC end USB_CC2, a second switching tube Q2 is additionally provided in the circuit diagram scheme of FIG. 2, which provides a logic inversion effect. In an embodiment, when the Type-C plug is inserted into the Type-C socket from the A side , the USB_VBUS end is at a high level, the USB_CC1 is at a high level, and the USB_CC2 is at a low level. In this case, the first switching tube Q1 is not turned on, such that the control end of the second switching tube Q2 is at a high level, and the second switching tube Q2 is turned on, so the drive end USB_DIR is at a low level. When the Type-C plug is inserted into the Type-C socket from the B side , the USB_VBUS end is at a high level, the USB_CC1 is at a low level, and the USB_CC2 is at a high level. In this case, the first switching tube Q1 is turned on, the second switching tube Q2 is not turned on, and the USB_DIR is at a high level. According to the circuit diagram provided in FIG. 2, the level of the drive end USB_DIR is synchronized with the level of the second CC end USB_CC2. The third resistor R3 and the second resistor R2 both function as pull-up resistors, such that potentials of the input ends of the first switching tube Q1 and the second switching tube Q2 are respectively maintained at a high level, thereby improving the stability of the detection circuit. In an embodiment, the third resistor R3 has a resistance of 47 kΩ, which is not limited in the present disclosure.

Still referring to FIG. 2, the delay filter circuit includes a fourth resistor R4 and a first capacitor C1. One end of the fourth resistor R4 is connected to one end of the first capacitor C1, the other end of the fourth resistor R4 is connected between the input end of the second switching tube Q2 and the third resistor R3, the other end of the first capacitor C1 is grounded, and the drive end is arranged between the fourth resistor R4 and the first capacitor C1. The delay filter circuit eliminates interference signals on the USB_VBUS, and satisfies timing of on and off of the first switching tube Q1 and the second switching tube Q2. In an embodiment, the fourth resistor R4 has a resistance of 1 kΩ, and the first capacitor C1 has a capacitance of 10 nF, which is not limited in the present disclosure.

Still referring to FIG. 2, the detection circuit provided by the present disclosure further includes a fifth resistor R5 and a sixth resistor R6, one end of the fifth resistor R5 and one end of the sixth resistor R6 are connected to the control end of the first switching tube Q1, the other end of the fifth resistor R5 is connected to the second CC end of the Type-C socket, and the other end of the sixth resistor R6 is grounded. In this circuit, the fifth resistor R5 functions as a protective resistor to prevent an excessive voltage from damaging the first switching tube Q1, and provides a voltage dividing function, and the sixth resistor R6 is a pull-down resistor, thereby improving the stability of the detection circuit.

It should be noted that the connection positions of the first CC end USB_CC1 and the second CC end USB_CC2 may be interchangeable, which is not limited in the present disclosure.

It should be noted that the first switching tube Q1 and the second switching tube Q2 may each be a transistor or a field effect transistor. In an embodiment of the present disclosure, the first switching tube Q1 and the second switching tube Q2 are NPN-type triodes. The input ends of the first switching tube Q1 and the second switching tube Q2 are collectors of the NPN-type triodes, the control ends of the first switching tube Q1 and the second switching tube Q2 are bases of the NPN-type triodes, and the output ends of the first switching tube Q1 and the second switching tube Q2 are emitters of the NPN-type triodes.

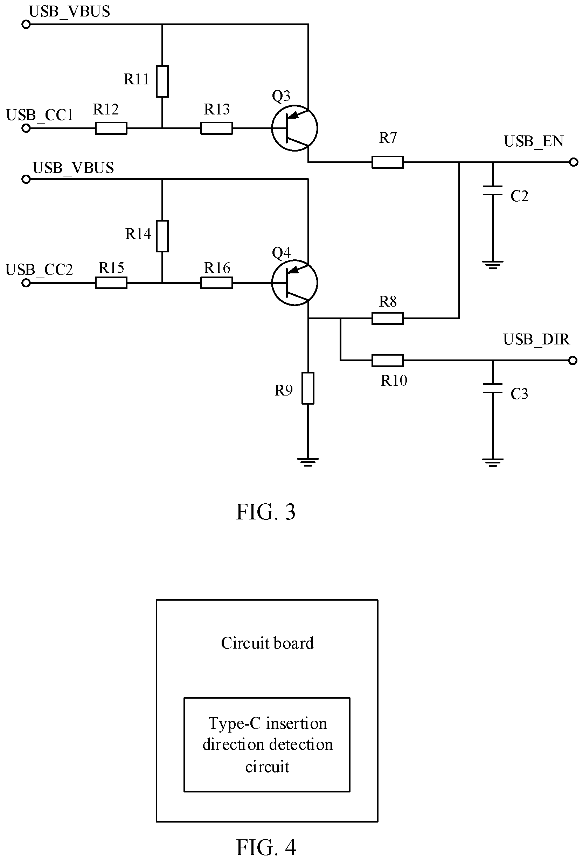

Referring to FIG. 3, in another embodiment, when the electronic device is a Host-type device, i.e., a master device, the switch module includes a third switching tube Q3 and a fourth switching tube Q4. An input end of the third switching tube Q3 is connected to the VBUS end of the Type-C socket. A control end of the third switching tube Q3 is connected to the first CC end of the Type-C socket and is connected to the VBUS end through a first resistor network. An output end of the third switching tube Q3 is grounded through a seventh resistor R7, an eighth resistor R8, and a ninth resistor R9 in sequence. An enable end is arranged between the seventh resistor R7 and the eighth resistor R8. The enable end is configured to indicate whether a Type-C plug is connected, and may further be configured to supply power to a subsequent driver chip. An input end of the fourth switching tube Q4 is connected to the VBUS end of the Type-C socket. A control end of the fourth switching tube Q4 is connected to the second CC end of the Type-C socket and is connected to the VBUS end through a second resistor network. An output end of the fourth switching tube Q4 is connected between the eighth resistor R8 and the ninth resistor R9. The drive end is arranged between the eighth resistor R8 and the ninth resistor R9 through a tenth resistor R10. The seventh resistor R7, the eighth resistor R8, and the ninth resistor R9 form a serial voltage divider circuit, which can influence the level at the drive end when the Type-C plug is inserted from the A side or the B side . In an embodiment, when the Type-C plug is inserted into the Type-C socket from the A side, the USB_VBUS end is at a high level. In this case, the first CC end USB_CC1 is connected to a pull-down resistor of a CC end in the Type-C plug, such that the USB_CC1 end is at a low level, and the third switching tube Q3 is turned on. Because the fourth switching tube Q4 does not satisfy a turn-on condition due to the action of the VBUS end and the second resistor network, the fourth switching tube Q4 is not turned on, and a current flows out from the VBUS end through the output end of the third switching tube Q3, and presents a high level at the enable end after passing through the seventh resistor R7. Under the action of the voltage divider circuit formed by the seventh resistor R7, the eighth resistor R8, and the ninth resistor R9, the drive end outputs a low level. Similarly, when the Type-C plug is inserted into the Type-C socket from the B side, the USB_VBUS end is at a high level. In this case, the second CC end USB_CC2 is connected to the pull-down resistor of the CC end of the Type-C plug, such that the USB_CC2 end is at a low level, and the fourth switching tube Q4 is turned on. Because the third switching tube Q3 does not satisfy a turn-on condition due to the action of the VBUS end and the first resistor network, the third switching tube Q3 is not turned on, and a current flows out from the VBUS end through the output end of the fourth switching tube Q4, presents a high level at the enable end after passing through the eighth resistor R8, and presents a high level at the drive end after passing through the tenth resistor R10. In other words, when the drive end is at a low level, it indicates that the Type-C plug is inserted into the Type-C socket from the A side ; when the drive end is at a high level, it indicates that the Type-C plug is inserted into the Type-C socket with the A side facing upward, and when the drive end is at a low level, it indicates that the Type-C plug is inserted into the Type-C socket from the B side . With the configuration of the third switching tube Q3, the fourth switching tube Q4, and the resistors, the insertion direction of the Type-C plug is detected by hardware, thereby effectively reducing the circuit costs and improving the reliability of the circuit.

It should be noted that the Host-type device may be a computer, a background controller, etc.

Still referring to FIG. 3, the seventh resistor R7 and the enable end are grounded through a second capacitor C2, the drive end is arranged between the eighth resistor R8 and the ninth resistor R9 through a tenth resistor R10, and the tenth resistor R10 and the drive end are grounded through a third capacitor C3. The circuit formed by the second capacitor C2, the tenth resistor R10, and the third capacitor C3 provides a filtering function, to make the levels at the enable end and the drive end more stable. In an embodiment, the second capacitor C2 and the third capacitor C3 may have a capacitance of 0.1 µF, and the tenth resistor R10 may have a resistance of 1 kΩ, which is not limited in the present disclosure.

Still referring to FIG. 3, the first resistor network includes an eleventh resistor R11, a twelfth resistor R12, and a thirteenth resistor R13. One end of the eleventh resistor R11, one end of the twelfth resistor R12, and one end of the thirteenth resistor R13 are connected to one another. The other end of the eleventh resistor R11 is connected to the VBUS end. The other end of the twelfth resistor R12 is connected to the first CC end. The other end of the thirteenth resistor R13 is connected to the control end of the third switching tube Q3. The second resistor network includes a fourteenth resistor R14, a fifteenth resistor R15, and a sixteenth resistor R16. One end of the fourteenth resistor R14, one end of the fifteenth resistor R15, and one end of the sixteenth resistor R16 are connected to one another. The other end of the fourteenth resistor R14 is connected to the VBUS end. The other end of the fifteenth resistor R15 is connected to the second CC end. The other end of the sixteenth resistor R16 is connected to the control end of the fourth switching tube Q4. In an embodiment, according to Type-C specifications, resistance values of the eleventh resistor R11 and the fourteenth resistor R14 are 12 kS2, resistance values of the twelfth resistor R12 and the fifteenth resistor R15 are 27 kS2, and resistance values of the thirteenth resistor R13 and the sixteenth resistor R16 are 4.7 kΩ, which are not particularly limited in the present disclosure.

It should be noted that the third switching tube Q3 and the fourth switching tube Q4 may each be a transistor or a field effect transistor. In an embodiment of the present disclosure, the third switching tube Q3 and the fourth switching tube Q4 are PNP-type triodes. The input ends of the third switching tube Q3 and the fourth switching tube Q4 are emitters of the PNP-type triodes, the control ends of the third switching tube Q3 and the fourth switching tube Q4 are bases of the PNP-type triodes, and the output ends of the third switching tube Q3 and the fourth switching tube Q4 are collectors of the PNP-type triodes.

The present disclosure further provides a circuit board, including the Type-C insertion direction detection circuit according to any of the above embodiments.

In addition, the present disclosure further provides an electronic device, including the circuit board according to the above embodiment.

In the embodiments of the present disclosure, the switch module is connected to the Type-C socket. In an embodiment, the input end of the switch module is connected to the VBUS end of the Type-C socket, the control end of the switch module is connected to the first CC end and/or the second CC end of the Type-C socket, and the output end of the switch module is the drive end. The VBUS end serves as an input end to provide voltage guarantee for an output level of an output end. The switch module changes its on/off status according to a level of the first CC end and/or the second CC end through internal electronic components, to change the current flow status from the input end to the output end. The drive end is configured to feed back the plugging relationship between the Type-C plug and the Type-C socket, i.e., feed back whether the Type-C plug is inserted from the A side or the B side. In the present disclosure, the insertion direction of the Type-C plug can be detected by the electronic components in the switch module, thereby effectively reducing the circuit costs and improving the reliability of the circuit.

Although some embodiments of the present disclosure have been described above, the present disclosure is not limited to the implementations described above. Those having ordinary skills in the art can make various equivalent modifications or replacements without departing from the essence of the present disclosure. Such equivalent modifications or replacements fall within the scope defined by the claims of the present disclosure.

## Claims

1. A Type-C insertion direction detection circuit, applied to an electronic device comprising a Type-C socket, the detection circuit comprising:
a switch module, having an input end configured to be connected to a VBUS end of the Type-C socket, the input end of the switch module is connected to a first CC end and/or a second CC end of the Type-C socket, and the switch module is configured to change an on/off status according to a first level received at the input end from the first CC end and/or the second CC end, and output a second level at a drive end of the switch module, for the electronic device to determine a plugging relationship between a Type-C plug and the Type-C socket according to the second level.

2. The detection circuit of claim 1, wherein in response to the electronic device being a driving device, the first CC end is grounded through a first resistor, and the switch module comprises: a first switching tube, wherein an input end of the first switching tube is connected to the VBUS end, a control end of the first switching tube is connected to the second CC end, an output end of the first switching tube is grounded, and the drive end is arranged between the input end of the first switching tube and the VBUS end.

3. The detection circuit according to claim 2, further comprising a delay filter circuit, wherein an input end of the delay filter circuit is connected between the input end of the first switching tube and the VBUS end, and an output end of the delay filter circuit is the drive end.

4. The detection circuit of claim 3, wherein a second resistor is arranged between the input end of the first switching tube and the VBUS end.

5. The detection circuit of claim 4, wherein the switch module further comprises a second switching tube arranged between the input end of the first switching tube and the delay filter circuit, an input end of the second switching tube is connected to the VBUS end through a third resistor, a control end of the second switching tube is connected between the input end of the first switching tube and the second resistor, an output end of the second switching tube is grounded, and the input end of the delay filter circuit is connected between the input end of the second switching tube and the third resistor.

6. The detection circuit of claim 5, wherein the delay filter circuit comprises a fourth resistor and a first capacitor, one end of the fourth resistor is connected to one end of the first capacitor, the other end of the fourth resistor is connected between the input end of the second switching tube and the third resistor, the other end of the first capacitor is grounded, and the drive end is arranged between the fourth resistor and the first capacitor.

7. The detection circuit according to claim 6, further comprising a fifth resistor and a sixth resistor, wherein one end of the fifth resistor and one end of the sixth resistor are connected to the control end of the first switching tube, the other end of the fifth resistor is connected to the second CC end of the Type-C socket, and the other end of the sixth resistor is grounded.

8. The detection circuit of claim 1, wherein in response to the electronic device being a master device, the switch module comprises:
a third switching tube, wherein an input end of the third switching tube is connected to the VBUS end of the Type-C socket, a control end of the third switching tube is connected to the first CC end of the Type-C socket and is connected to the VBUS end through a first resistor network, an output end of the third switching tube is grounded through a seventh resistor, an eighth resistor, and a ninth resistor in sequence, and an enable end is arranged between the seventh resistor and the eighth resistor; and
a fourth switching tube, wherein an input end of the fourth switching tube is connected to the VBUS end of the Type-C socket, a control end of the fourth switching tube is connected to the second CC end of the Type-C socket and is connected to the VBUS end through a second resistor network, and an output end of the fourth switching tube is connected between the eighth resistor and the ninth resistor;
wherein the drive end is arranged between the eighth resistor and the ninth resistor.

9. The detection circuit of claim 8, wherein the seventh resistor and the enable end are grounded through a second capacitor, the drive end is arranged between the eighth resistor and the ninth resistor through a tenth resistor, and the tenth resistor and the drive end are grounded through a third capacitor.

10. The detection circuit of claim 9, wherein the first resistor network comprises an eleventh resistor, a twelfth resistor, and a thirteenth resistor, one end of the eleventh resistor, one end of the twelfth resistor, and one end of the thirteenth resistor are connected to one another, the other end of the eleventh resistor is connected to the VBUS end, the other end of the twelfth resistor is connected to the first CC end, and the other end of the thirteenth resistor is connected to the control end of the third switching tube; and the second resistor network comprises a fourteenth resistor, a fifteenth resistor, and a sixteenth resistor, one end of the fourteenth resistor, one end of the fifteenth resistor, and one end of the sixteenth resistor are connected to one another, the other end of the fourteenth resistor is connected to the VBUS end, the other end of the fifteenth resistor is connected to the second CC end, and the other end of the sixteenth resistor is connected to the control end of the fourth switching tube.

11. A circuit board, comprising the detection circuit of any of claims 1 to 9.

12. An electronic device, comprising the circuit board of claim 10.
